# EUROPÄISCHE PATENTSCHRIFT

(11) **EP 2 439 427 B1**
(45) Veröffentlichungstag und Bekanntmachung des Hinweises auf die Patenterteilung: **17.04.2013**
(21) Anmeldenummer: 11180354.0
(22) Anmeldetag: 07.09.2011
(51) Int. Cl.: F16H 59/70, G01D 5/14, G01R 33/00

(54) **Stellglied zur Auswahl mindestens eines auswählbaren Schaltzustands**
Positioning member for selecting at least one selectable switching status
Actionneur pour la sélection d'au moins un état de commutation sélectionnable

(30) Priorität: 06.10.2010 DE 102010042023
(43) Veröffentlichungstag der Anmeldung: 11.04.2012
(73) Patentinhaber: Robert Bosch GmbH, 70442 Stuttgart (DE)
(72) Erfinder: Oetting, Claus-Christian, 87544 Blaichach (DE); Mueller, Wolfgang-Michael, Yokohama, Kanagawa, 224-8501 (JP); Glasenapp, Rayk, 07629 Reichenbach (DE); Yashan, Andre, 70191 Stuttgart (DE); Gruschwitz, Peggy, 99817 Eisenach (DE)

(56) Entgegenhaltungen:
- EP-A1- 1 832 783
- EP-A1- 2 151 608
- EP-A2- 1 548 408
- DE-A1- 19 748 115
- US-A1- 2002 003 527

## Beschreibung

### Stand der Technik

Die vorliegende Erfindung betrifft ein Stellglied zur Auswahl mindestens eines auswählbaren Schaltzustandes und ein ein derartiges Stellglied umfassendes Schaltgetriebe. Aus dem Stand der Technik sind Drehzahlsensoren bekannt, welche auf der Verwendung magnetischer Polräder basieren. Beispiele derartiger Drehzahlsensoren sind in Robert Bosch GmbH: Sensoren im Kraftfahrzeug, Ausgabe 2007, S. 57-68 beschrieben. Weiterhin sind Stellglieder bekannt, die ein um eine Achse rotierbares Element und ein statisches Element aufweisen, wobei das statische Element mit einem Magnetfeldsensor und das rotierbare Element mit einem Magneten ausgestattet ist. Dabei ist das statische Element derart bezüglich des rotierbaren Elementes angeordnet, dass mit dem Magnetfeldsensor des statischen Elementes das Magnetfeld des Magneten detektiert werden kann. Rotiert nun das rotierbare Element um seine Achse, so kann mittels des Magnetfeldsensors ein im Verlaufe der Rotation veränderliches Magnetfeld durch den Magnetfeldsensor detektiert werden. Üblicherweise ist der Magnet hinsichtlich seiner Magnetpole radial ausgerichtet. Somit ist in einer vorbestimmten Stellung des rotierbaren Elementes, bei dem der Magnet den geringsten Abstand zum Magnetfeldsensor aufweist, ein Magnetpol des Magneten zum Magnetfeldsensor orientiert, während der andere Magnetpol des Magneten zur Achse orientiert ist. Bei einer derartigen radialen Ausrichtung des Magneten ist durch den Magnetfeldsensor ein Magnetfeld detektierbar, das bei der vorbestimmten Stellung des rotierbaren Elementes ein Maximum aufweist. Wird nun das rotierbare Element aus dieser vorbestimmten Stellung ausgelenkt, so sinkt das Magnetfeld ab, beispielsweise indem dieses bei größeren Auslenkungen asymptotisch zu einer Nulllinie verläuft.

DE 19748115 A offenbart ein Stellgliede gemäß dem Oberbegriff des Anspruchs 1.

Derartige Stellglieder können zu einer Neutralgangdetektion verwendet werden, wobei in diesem Fall der Magnetfeldsensor in der Regel mit einem integrierten Schaltkreis (IC) oder einem anwendungsspezifischen integrierten Schaltkreis (ASIC) ausgestattet oder integriert mit demselben ausgebildet sein kann. Zum Zwecke der Detektion der vorbestimmten Stellung ist üblicherweise in dem jeweiligen integrierten Schaltkreis eine Schaltschwelle implementiert. Wird diese Schaltschwelle erreicht, über- oder unterschritten, dann wird von dem integrierten Schaltkreis ein Signal ausgelöst. Aufgrund des ausgelösten Signals kann somit die vorbestimmte Stellung des rotierbaren Elements registriert werden.

Bei einer derartigen Ausführungsform ist die durch den Magnetfeldsensor detektierbare Magnetfeldkennlinie im Bereich des Maximums umso breiter, je höher die laterale Ausdehnung des Magneten ist. Zur Erhöhung der Genauigkeit bei der Detektion der vorbestimmten Stellung, ist jedoch eine schmale Magnetfeldkennlinie im Bereich des Maximums vorteilhaft, da in diesem Fall die vorbestimmte Stellung des rotierbaren Elementes in einem kleineren Winkelbereich der Auslenkung des rotierbaren Elementes aus der vorbestimmte Stellung detektiert werden kann. Um einen derartigen schmalen Verlauf der Magnetfeldkennlinie zu erhalten, können schmale Magnete eingesetzt werden. Diese schmalen Magnete brechen jedoch bei der Montage leicht und lassen sich auch nicht gut mittels eines Spritzgussverfahrens umspritzen. Des Weiteren wirken sich bei einer derartigen Ausführungsform Toleranzen im Bereich der Geometrie und auch im Bereich des Magnetfeldsensors auf die Genauigkeit des Stellgliedes aus. Wünschenswert wäre demzufolge ein Stellglied, das zumindest hinsichtlich seines Magneten robuster aufgebaut ist und bei dem sich zumindest die Toleranzen und die Ausbildung des Magneten geringer auf die Genauigkeit des Stellgliedes auswirken.

### Offenbarung der Erfindung

In einem ersten Aspekt der Erfindung wird ein Stellglied zur Auswahl mindestens eines auswählbaren Schaltzustands vorgeschlagen. Unter einem Stellglied wird allgemein im Rahmen der vorliegenden Erfindung eine Vorrichtung verstanden, mittels derer mindestens ein bestimmter Schaltzustand auswählbar ist, also durch einen Benutzer und/oder eine andere Vorrichtung gezielt beeinflussbar ist. Alternativ oder zusätzlich kann das Stellglied jedoch auch sensorische Funktionen aufweisen, also eingerichtet sein, um zu erkennen, ob mindestens ein bestimmter Schaltzustand ausgewählt ist. Das Stellglied kann also für eine aktive Beeinflussung des Schaltzustands und/oder für eine Erkennung des Schaltzustands eingerichtet sein. Bei dem auswählbaren Schaltzustand kann es sich insbesondere um mindestens eines Schaltzustands eines Getriebes handeln, beispielsweise in einem Kraftfahrzeug. Insbesondere kann das Stellglied eingerichtet sein, um eine Neutralgangdetektion durchzuführen. Grundsätzlich sind jedoch auch andere Arten von Schaltzuständen möglich, so dass unter einem Schaltzustand grundsätzlich ein beliebiger einstellbarer Zustand verstanden werden kann.

Das Stellglied umfasst mindestens zwei relativ zueinander bewegbare Elemente. Beispielsweise kann das Stellglied derart ausgestaltet sein, dass mindestens eine Führung und/oder mindestens eine Lagerung vorgesehen ist, wobei die Elemente durch die Führung und/oder Lagerung relativ zueinander bewegbar geführt und/oder gelagert sind. Die Relativbewegung kann derart erfolgen, dass mindestens ein erstes der Elemente ruht, also statisch ausgestaltet ist, und dass jeweils mindestens eine andere der Elemente relativ zu dem ersten Element bewegt wird. Alternativ können auch beide Elemente zueinander bewegt werden. Die Bewegung kann grundsätzlich beliebig ausgestaltet werden, wobei eine oder mehrere translatorische Bewegungen und/oder eine oder mehrere rotatorische Bewegungen der Elemente zueinander möglich sind. Die Erfindung wird im folgenden im Wesentlichen unter Bezugnahme auf eine Rotationsbewegung der Elemente zueinander beschrieben, insbesondere um eine Achse, wobei jedoch auch andere Bewegungsarten möglich sind, beispielsweise Rotationsbewegungen um mehrere Achsen und/oder Translationsbewegungen mit einer oder mehreren Richtungen. Auch reine Translationsbewegungen sollen im Rahmen der vorliegenden Erfindung möglich sein.

Mindestens eines der relativ zueinander bewegbaren Elemente weist mindestens einen Magnetfelderzeuger auf, und das jeweils andere der Elemente weist mindestens einen Magnetfeldsensor auf. Der Magnetfelderzeuger ist eingerichtet, um bei einer Bewegung der Elemente relativ zueinander, insbesondere bei einer Rotation, des am Ort des Magnetfeldsensors ein Magnetfeld mit mindestens einem Vorzeichenwechsel bei mindestens einem, vorzugsweise genau einem, Nulldurchgang zu erzeugen.

Der Magnetfeldsensor und/oder oder das Stellglied können insbesondere eingerichtet sein, um mindestens ein Signal zu erzeugen, welches ausgegeben werden kann, beispielsweise über eine Schnittstelle. Alternative zusätzlich kann das mindestens eine Signal auch beispielsweise von dem Magnetfeldsensor an eine optionale Steuerung übermittelt werden, welche Bestandteil des Stellgliedes sein kann oder welche auch separat ausgebildet sein kann. Dieses mindestens eine Signal kann beispielsweise bei dem Vorzeichenwechsel des Magnetfelds den oben genannten Nulldurchgang aufweisen. Das mindestens eine Signal kann beispielsweise mindestens ein analoges Signal und/oder mindestens ein digitales Signal umfassen. Das mindestens eine Signal kann beispielsweise mindestens ein elektrisches Signal umfassen, beispielsweise mindestens eine Spannung und/oder mindestens einen Strom und/oder mindestens eine Frequenz. Das mindestens eine Signal kann kontinuierlich oder auch diskontinuierlich ausgestaltet sein. Auch Kombinationen analoger und digitaler Signale sind möglich. Beispielsweise kann das Signal in einem Zwischenbereich möglicher Stellungsbereiche der Elemente zueinander kontinuierlich die Stellung der Elemente zueinander wiedergeben, beispielsweise durch ein kontinuierlich mit der relativen Stellung der Elemente zueinander variierendes Signal, wohingegen außerhalb dieses Zwischenbereichs beispielsweise fest vorgegebene Werte angenommen werden. Verschiedene andere Ausgestaltungen sind möglich.

Das Stellglied weist vorzugsweise mindestens eine Steuerung auf, wobei die Steuerung vorzugsweise eingerichtet ist, um das Magnetfeld mit mindestens einer unteren Schaltschwelle und mindestens einer oberen Schaltschwelle zu vergleichen und entsprechend dieser Vergleiche zu erkennen, dass der Schaltzustand ausgewählt ist. Die optionale Steuerung kann einstückig mit den übrigen Komponenten des Stellgliedes ausgestaltet sein, beispielsweise in einem gemeinsamen Gehäuse mit dem Magnetfelderzeuger und/oder dem Magnetfeldsensor. Alternativ oder zusätzlich kann die Steuerung jedoch auch eine oder mehrere separate Komponenten umfassen, beispielsweise eine oder mehrere Komponenten, welche nicht-einstückig mit dem Magnetfeldsensor und/oder dem Magnetfelderzeuger und/oder eines Gehäuses einer oder mehrerer dieser Komponenten ausgebildet sind. Beispielsweise kann die Steuerung auch vollständig oder teilweise in eine zentrale Motorsteuerung integriert sein. Die Steuerung kann zentral oder auch dezentral ausgestaltet sein. Die Steuerung kann insbesondere eine oder mehrere elektronische Komponenten und/oder eine oder mehrere Datenverarbeitungsvorrichtungen umfassen, beispielsweise einen oder mehrere Komparatoren und/oder einen oder mehrere Microcontroller, insbesondere um die Vergleiche durchzuführen.

Wie oben ausgeführt, können die relativ zueinander bewegbaren Elemente insbesondere ein um eine Achse rotierbares Element und mindestens ein statisches Element aufweisen. Der Magnetfelderzeuger kann insbesondere mit dem rotierbaren Element verbunden sein, und der Magnetfeldsensor kann insbesondere mit dem statischen Element verbunden sein. Das rotierbare Element kann insbesondere mindestens eine Welle umfassen, beispielsweise eine Getriebewelle. Das rotierbare Element kann insbesondere weiterhin mindestens einen auf die Welle aufgebrachten Aufsatz umfassen, vorzugsweise einen nicht-rotationssymmetrischen Aufsatz, wobei der Aufsatz den Magnetfelderzeuger und vorzugsweise den unten noch näher beschriebenen Stützfelderzeuger umfassen kann. Es wird darauf hingewiesen, dass jedoch, wie oben bereits ausgeführt, auch andere Arten von Relativbewegungen der Elemente zueinander möglich sind, beispielsweise eine Rotationsbewegung um mehr als eine Achse und/oder eine Translationsbewegung.

Das durch den Magnetfelderzeuger am Ort des Magnetfeldsensors erzeugte Magnetfeld weist also mindestens einen Nulldurchgang bei der Relativbewegung der Elemente zueinander auf, insbesondere bei einer Rotation des rotierbaren Elementes um die Achse. Beispielsweise kann dieser Nulldurchgang auftreten, wenn der Magnetfelderzeuger eine Winkelstellung überstreicht, in welcher auch der Magnetfeldsensor angeordnet ist und/oder wenn der Magnetfelderzeuger sich an dem Magnetfeldsensor vorbei bewegt. Insbesondere kann das Magnetfeld am Ort des Magnetfeldsensors bei dem Nulldurchgang einen Vorzeichenwechsel aufweisen. Dadurch sind insgesamt kleinere Winkelbereiche zur Detektion der vorbestimmten Stellung des rotierbaren Elementes darstellbar. Weiterhin sinken die Anforderungen hinsichtlich der Dimensionierung des Magnetfelderzeugers, so dass beispielsweise größere und damit robustere Magnetfelderzeuger, beispielsweise Permanentmagnete, eingesetzt werden können. Durch einen größeren Magnetfelderzeuger ist zudem eine vereinfachte Montage möglich, und aufgrund der höheren Stabilität des Magnetfelderzeugers sind geringere Ausschusskosten zu erwarten.

Die relativ zueinander bewegbaren Elemente des Stellgliedes können grundsätzlich beliebige Elemente des Stellgliedes sein. Das optionale rotierbare Element kann insbesondere eine Getriebewelle sein, die in einem Schaltgetriebe für ein Kraftfahrzeug, insbesondere mit Start-Stopp-Automatik, eingesetzt wird. Auch andere Ausgestaltungen und Einsatzgebiete sind möglich. Das optionale statische Element kann grundsätzlich ein beliebiges Element sein, das gegenüber dem rotierbaren Element vorzugsweise ortsfest angeordnet ist, wobei das rotierbare Element gegenüber dem statischen Element verdrehbar ausgebildet ist.

Da eines der Elemente einen Magnetfelderzeuger aufweist, während das andere Element mit einem Magnetfeldsensor ausgestattet ist, kann bei einer Relativbewegung, beispielsweise einer Translationsbewegung und/oder einer Rotation des rotierbaren Elementes, mittels des Magnetfeldsensors ein in Abhängigkeit von der Relativbewegung und/oder Rotation veränderliches Magnetfeld registriert werden. Dabei sind der Magnetfelderzeuger und der Magnetfeldsensor bevorzugt in einer gemeinsamen Bewegungsebene angeordnet, beispielsweise einer gemeinsamen Rotationsebene, beispielsweise einer Rotationsebene senkrecht zu der Achse. Wenn beispielsweise der Magnetfelderzeuger an dem rotierbaren Element angeordnet ist, so kann dieser bei der Rotation des rotierbaren Elementes eine Rotationsebene aufspannen. Bevorzugt liegt dabei der Magnetfeldsensor ebenfalls in dieser durch den Magnetfelderzeuger aufgespannten Rotationsebene.

Bevorzugt ist mittels des Stellgliedes zumindest eine Stellung der Elemente zueinander, also beispielsweise mindestens eine Relativposition und/oder mindestens eine relative Winkelstellung, einstellbar und/oder mindestens eine vorbestimmte Stellung der Elemente zueinander detektierbar. Beispielsweise kann dies diejenige Stellung sein, bei der der Magnetfelderzeuger zum Magnetfeldsensor den geringsten Abstand aufweist. Der Magnetfelderzeuger kann insbesondere der Art eingerichtet sein, dass dieser beim Passieren der vorbestimmten Stellung einen Vorzeichenwechsel des durch den Magnetfeldsensor detektierbaren Magnetfeldes aufweist. So kann die mindestens eine vorbestimmte Stellung mittels des Stellgliedes mit hoher Genauigkeit ermittelt werden.

Des Weiteren ist das Stellglied optional mit der mindestens einen oben genannten Steuerung ausgestattet. Eine derartige Steuerung kann beispielsweise mindestens eine elektronische Schaltung und/oder mindestens eine Datenverarbeitungsvorrichtung umfassen. Insbesondere kann die Steuerung mindestens einen integrierten Schaltkreis (IC) und/oder mindestens einen anwendungsspezifischen integrierten Schaltkreis (ASIC) umfassen. Beispielsweise können mindestens ein integrierter Schaltkreis und/oder mindestens ein anwendungsspezifischer integrierter Schaltkreis vorgesehen sein, welche mit dem Magnetfeldsensor verbunden sind und/oder integral mit diesem ausgebildet sind. Wie oben beschrieben, sind jedoch auch andere Ausgestaltungen möglich, beispielsweise eine oder mehrere Steuerungen, welche getrennt von dem Magnetfelderzeuger und/oder getrennt von dem Magnetsensor ausgebildet sind, beispielsweise indem die Steuerung vollständig oder teilweise in eine Motorsteuerung eines Kraftfahrzeugs integriert wird.

Die optionale Steuerung ist eingerichtet, um das Magnetfeld mit mindestens einer unteren Schaltschwelle und mindestens einer oberen Schaltschwelle zu vergleichen und entsprechend dieser Vergleiche zu erkennen, dass der Schaltzustand ausgewählt ist, also zu erkennen, ob der Schaltzustand vorliegt oder nicht.

Beispielsweise kann zur Detektion einer vorbestimmten Stellung der Elemente zueinander der Nulldurchgang verwendet werden, oder es kann die Steuerung mit einer unteren und einer oberen Schaltschwelle ausgestattet sein. Wird das Magnetfeld durch den Magnetfeldsensor detektiert, so kann insbesondere der jeweilig ermittelte Wert mit der oberen und der unteren Schaltschwelle verglichen und aufgrund des Vergleiches entschieden werden, ob der Schaltzustand vorliegt, beispielsweise ob die vorbestimmte Stellung erreicht ist oder nicht. Die vorbestimmte Stellung kann dabei einem Schaltzustand entsprechen, so dass bei Erreichen zumindest einer vorbestimmten Stellung die Steuerung erkennen kann, dass der Schaltzustand ausgewählt ist. Sind die Elemente zueinander beispielsweise aus einer vordefinierten Stellung ausgelenkt, so kann aufgrund des Vergleichs des Magnetfeldes mit der oberen und der unteren Schaltschwelle ebenfalls erkannt werden, dass der Schaltzustand nicht ausgewählt ist. Beispielsweise mittels eines Magnetfeldkennliniendiagramms und/oder mittels eines entsprechenden Algorithmus können die obere Schaltschwelle und die untere Schaltschwelle jeweils in relative Stellungen der Elemente zueinander, beispielsweise eine oder mehrere translatorische Stellungen und/oder eine oder mehrere Winkelstellungen und/oder Winkelbereiche, übersetzt werden, wobei bei Erreichen dieser Stellungen der Schaltzustand ausgewählt sein kann oder beim Auslenken des Elemente aus diesen Stellungen der Schaltzustand nicht ausgewählt ist. Aufgrund des Nulldurchganges und des Vorzeichenwechsels des mittels des Magnetfeldsensors detektierbaren Magnetfeldes sind bei translatorischen Bewegungen kleinere translatorische Bereiche und bei Rotationsbewegungen kleinere Winkelbereiche zur Detektion der vorbestimmten Stellung möglich. Dabei kann eine vorbestimmte Stellung der zueinander bewegbaren Elemente beispielsweise ein Neutralgang eines Getriebes sein.

Die untere Schaltschwelle und die obere Schaltschwelle können insbesondere entgegengesetzte Vorzeichen aufweisen. Weiterhin kann die Steuerung eingerichtet sein, um eine Auswahl des Schaltzustandes zu erkennen, wenn eine Kombination von Vergleichsergebnissen der Vergleiche mindestens eine Bedingung erfüllt und ansonsten zu erkennen, dass der Schaltzustand nicht ausgewählt ist. Dabei kann die Bedingung aus folgender Gruppe ausgewählt sein: Das Magnetfeld erreicht mindestens die untere Schaltschwelle und maximal die obere Schaltschwelle; das Magnetfeld erreicht mindestens die untere Schaltschwelle und ist kleiner als die obere Schaltschwelle; das Magnetfeld ist größer als die untere Schaltschwelle und erreicht maximal die obere Schaltschwelle; das Magnetfeld ist größer als die untere Schaltschwelle und kleiner als die obere Schaltschwelle.

Der Magnetfelderzeuger weist insbesondere mindestens einen Magneten auf. Dabei mindestens ein Permanentmagnet verwendet und bevorzugt mindestens ein Dipol-Permanentmagnet. Ein derartiger Magnet kann zumindest einen Nordpol und zumindest einen Südpol auf, wobei eine Verbindungslinie zwischen dem Nordpol und dem Südpol mindestens eine parallel zu der Bewegung oder Bewegungsrichtung der Elemente zueinander verlaufende Richtungskomponente aufweist, vorzugsweise mindestens eine nicht radial zu der Achse einer Rotation der Elemente zueinander verlaufende Richtungskomponente aufweisen kann. Bevorzugt überwiegt der nicht radiale Anteil der Richtungskomponente gegenüber dem radialen Anteil, und vorzugsweise weist die Verbindungslinie keinen radialen Richtungskomponentenanteil auf. In diesem Fall verläuft die Verbindungslinie azimutal zu der Achse. Bei einer rein translatorischen Bewegung verläuft die Verbindungslinie vorzugsweise parallel zu der Translationsbewegung.

Bezüglich der Verteilung des Magnetfelderzeugers und des Magnetfeldsensors auf die zueinander bewegbaren Elemente, insbesondere auf das rotierbare Element und das statische Element, bestehen mehrere Möglichkeiten. Besonders bevorzugt können der Magnetfelderzeuger mit dem rotierbaren Element und der Magnetfeldsensor mit dem statischen Element verbunden sein. Auch andere Ausgestaltungen sind jedoch möglich.

Weiterhin kann der Magnetfelderzeuger insbesondere derart eingerichtet sein, dass das Magnetfeld bei einer Relativbewegung der Elemente zueinander, beispielsweise einer Translationsbewegung und/oder bei einer Rotation des rotierbaren Elementes um die Achse, einen symmetrischen Verlauf zum Nulldurchgang aufweist. Dies ist im Falle der Ausbildung des Magnetfelderzeugers als Magnet insbesondere dann der Fall, wenn die Verbindungslinie zwischen Nordpol und Südpol bei einer Translationsbewegung keine Komponente parallel zur Translationsrichtung und/oder bei einer Rotationsbewegung keine radiale Richtungskomponente aufweist und insbesondere, wenn die Verbindungslinie azimutal zu der Achse verläuft.

Das Magnetfeld am Ort des Magnetfeldsensors kann symmetrisch zum Nulldurchgang ein Minimum und ein Maximum aufweisen, wobei in dieser bevorzugten Ausführungsform vorzugsweise das Minimum und das Maximum des Magnetfeldes betragsmäßig gleich groß sind. Insbesondere in dieser oder auch in anderen Ausgestaltungen können die untere Schaltschwelle und die obere Schaltschwelle betragsmäßig gleich groß gewählt werden, beispielsweise mit entgegengesetzten Vorzeichen, und Fehlschaltungen der Steuerung können zuverlässig vermieden werden.

Des Weiteren ist das Stellglied derartig ausgebildet, dass der Nulldurchgang des detektierbaren Magnetfeldes einen ersten Stellungsbereich der Elemente relativ zueinander von einem zweiten Stellungsbereich der Elemente zueinander trennt. Unter einem Stellungsbereich ist dabei jeweils eine Menge möglicher Stellungen der Elemente zueinander zu verstehen, beispielsweise ein Bereich einer relativen Ausrichtung und/oder Orientierung der Elemente zueinander. Beispielsweise kann der Nulldurchgang einen ersten Winkelstellungsbereich von einem zweiten Winkelstellungsbereich trennen. Bei einer Translationsbewegung kann beispielsweise der Nulldurchgang einen ersten Stellungsbereich von einem zweiten Stellungsbereich trennen, wobei sich beispielsweise in dem ersten Stellungsbereich ein erstes der Elemente links von einem zweiten der Elemente befinden kann, und in dem zweiten Stellungsbereich rechts, oder umgekehrt. Auch andere Ausgestaltungen sind möglich. Das Magnetfeld am Ort des Magnetfeldsensors weist in dem ersten Stellungsbereich ein negatives Vorzeichen auf und in dem zweiten Stellungsbereich ein positives Vorzeichen.

Der Magnetfelderzeuger weist weiterhin mindestens einen Stützfelderzeuger auf. Der Stützfelderzeuger ist eingerichtet, um dem Magnetfeld am Ort des Magnetfeldsensors in zumindest einem Teilbereich des ersten Stellungsbereichs ein Stütz-Magnetfeld mit negativen Vorzeichen zu überlagern oder, alternativ oder zusätzlich, um dem Magnetfeld am Ort des Magnetfeldsensors in zumindest einem Teilbereich des zweiten Stellungsbereichs mindestens ein Stütz-Magnetfeld mit positivem Vorzeichen zu überlagern. Es können auch zumindest zwei Stützfelderzeuger vorgesehen sein, wobei mindestens ein erster der Stützfelderzeuger in zumindest einem Teilbereich des ersten Winkelstellungsbereichs dem Magnetfeld am Ort des Magnetfeldsensors ein Stütz-Magnetfeld mit negativen Vorzeichen überlagert und mindestens ein zweiter der Stützfelderzeuger dem Magnetfeld am Ort des Magnetfeldsensors ein Stütz-Magnetfeld mit positivem Vorzeichen überlagert.

Vorteilhaft kann durch den mindestens einen Stützfelderzeuger das betragsmäßige Absinken des Magnetfeldes beim Auslenken des rotierbaren Elementes hinausgezögert werden. Dadurch kann das betragsmäßige Absinken des Magnetfeldes zu größeren Auslegungen der Elemente zueinander, beispielsweise zu einem höheren Abstand der Elemente und/oder zu höheren relativen Winkelstellungen, hin verschoben werden. Bevorzugt wird dabei das betragsmäßige Absinken des Magnetfeldes unter die obere oder untere Schaltschwelle hinausgezögert.

Der Stützfelderzeuger kann insbesondere zumindest einen Stützmagneten aufweisen, vorzugsweise mindestens einen Permanentmagneten und besonders bevorzugt mindestens einen Dipol-Permanentmagneten. Ein derartiger Stützmagnet weist vorzugsweise zumindest einen Nordpol und zumindest einen Südpol auf, wobei eine Verbindungslinie zwischen dem Nordpol und dem Südpol vorzugsweise mindestens eine Richtungskomponente senkrecht zu der Bewegung der Elemente zueinander, beispielsweise senkrecht zu einer Translationsrichtung und/oder radial zu der Achse einer Rotation, aufweist. Bevorzugt ist die Verbindungslinie zwischen Nordpol und Südpol bei einer Rotationsbewegung radial orientiert, sodass die Verbindungslinie keine nicht-radiale Richtungskomponente aufweist. Vorzugsweise können zumindest zwei Stützmagnete auf einander gegenüberliegenden Seiten des Magnetfelderzeugers vorgesehen sein. Bevorzugt sind dabei die Stützmagnete symmetrisch zu dem Magnetfelderzeuger ausgerichtet. Insbesondere beim Einsatz von zwei Stützmagneten kann das betragsmäßige Absinken des Magnetfeldes in beiden Rotationsrichtungen hinausgezögert werden.

Die Stützmagnete auf den einander gegenüberliegenden Seiten des Magnetfelderzeugers können zueinander entgegengesetzt ausgerichtet sein. Beispielsweise können bei einer Rotationsbewegung die Stützmagnete insbesondere zu einem Magnet des Magnetfelderzeugers derartig ausgerichtet sein, dass jeweils der radial nach außen orientierte Magnetpol des jeweiligen Stützmagneten und der zu diesem Stützmagneten orientierte Magnetpol des Magneten des Magnetfelderzeugers die gleiche Polung besitzen. Bei einer derartigen Anordnung der Stützmagnete auf den einander gegenüberliegenden Seiten des Magnetfelderzeugers sind somit die Stützmagnete zueinander entgegengesetzt ausgerichtet, das bedeutet, dass ein Stützmagnet mit seinem Nordpol radial nach außen orientiert ist, während der auf der gegenüberliegenden Seite liegende Stützmagnet mit seinem Südpol radial nach außen orientiert ist.

Das optionale rotierbare Element des Stellgliedes kann insbesondere zumindest eine Welle umfassen. Das rotierbare Element kann weiterhin mindestens einen auf die Welle aufgebrachten Aufsatz umfassen, einen nicht-rotationssymmetrischen Aufsatz. Der Aufsatz kann den Magnetfelderzeuger und vorzugsweise auch den mindestens einen Stützfelderzeuger umfassen. Der Aufsatz kann beispielsweise mittels Spritzgussverfahren, insbesondere mittels Kunststoffspritzgussverfahren oder ähnlicher Techniken, auf die Welle aufgebracht werden.

In einem weiteren Aspekt der vorliegenden Erfindung wird ein Schaltgetriebe zum Einsatz in einem Kraftfahrzeug vorgeschlagen, insbesondere zum Einsatz in einem Kraftfahrzeug mit Start-Stopp-Automatik. Das Schaltgetriebe umfasst mindestens ein Stellglied zur Auswahl mindestens eines auswählbaren Schaltzustandes des Schaltgetriebes. Das Stellglied ist gemäß einer oder mehreren der vorhergehend beschriebenen Ausführungsformen ausgestaltet.

### Kurze Beschreibung der Zeichnungen

Ausführungsbeispiele sind in den Figuren schematisch dargestellt und werden in der nachfolgenden Beschreibung näher erläutert.

Es zeigen:
- Fig. 1: ein nicht erfindungsgemäßes Stellglied mit einem azimutal ausgerichteten Magneten,
- Fig. 2: eine Magnetfeldkennlinie des Stellgliedes nach Fig. 1 mit einem azimutal ausgerichteten Magneten,
- Fig. 3: ein erfindungsgemäßes Stellglied mit einem azimutal ausgerichteten Magneten und zwei vorwiegend radial orientierten Stützmagneten,
- Fig. 4: eine Magnetfeldkennlinie eines Stellgliedes mit einem azimutal ausgerichteten Magneten und zwei vorwiegend radial ausgerichteten Stützmagneten.

### Ausführungsformen der Erfindung

Im Folgenden werden Ausführungsbeispiele erfindungsgemäßer Stellglieder 110, 110' beschrieben, bei welchen eine Rotationsbewegung zweier Elemente 102 bzw. 102' und 104 relativ zueinander erfolgt. Es wird darauf hingewiesen, dass die Erfindung jedoch nicht auf derartige Rotationsbewegungen beschränkt ist sondern dass, alternativ oder zusätzlich, auch Translationsbewegungen möglich sind, wie oben ausgeführt.

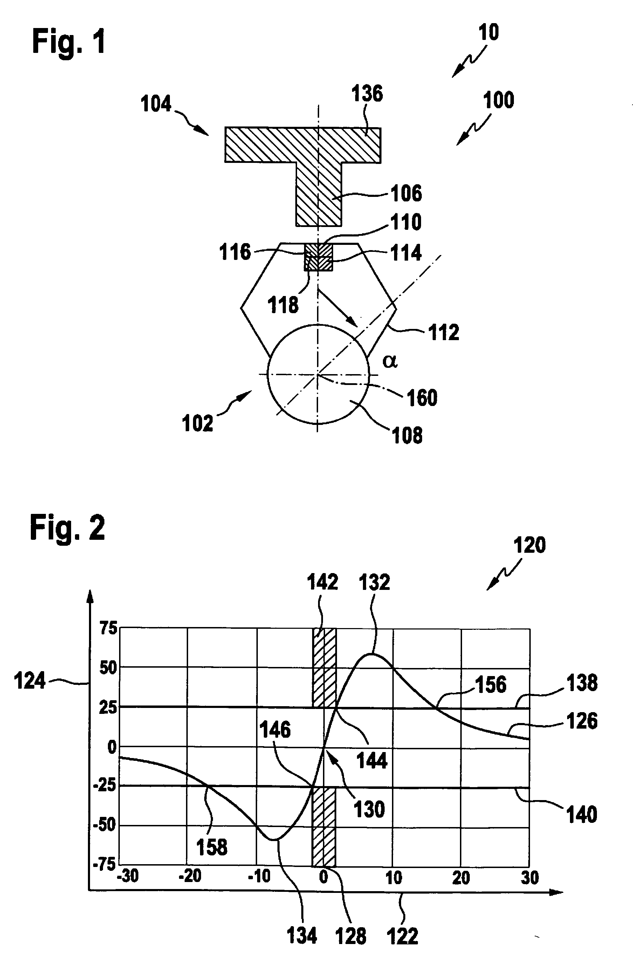

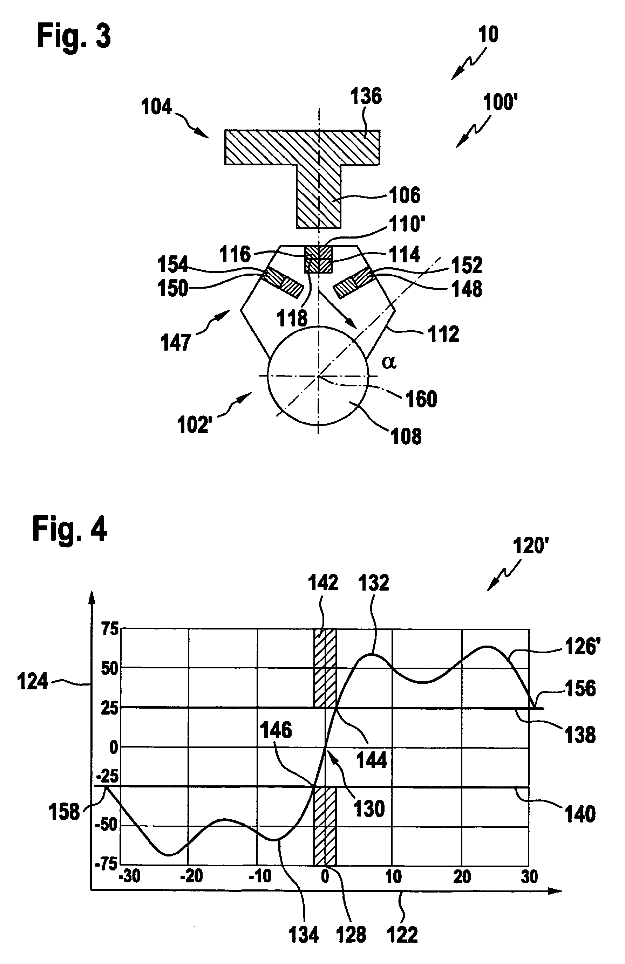

In Figur 1 ist ein Ausführungsbeispiel eines Stellgliedes 100 dargestellt, welches beispielsweise Bestandteil eines Schaltgetriebes 10 sein kann. Das Stellglied 100 weist in der Darstellung gemäß Figur 1, anhand derer zunächst eine besonders bevorzugte Ausführungsvarianten unter Verwendung von zwei Schaltschwellen 138, 140 erläutert werden soll, noch keinen Stützfelderzeuger 147 auf. Dieser kann jedoch analog zu Figur 3 ergänzt werden, um die Darstellung gemäß Figur 1 erfindungsgemäß auszugestalten. Grundsätzlich ist jedoch in diesem oder auch in anderen Ausführungsformen auch eine nicht erfindungsgemäße Ausgestaltung ohne Stützfelderzeuger 147 realisierbar.

Das in der Fig. 1 dargestellte Stellglied 100 weist ein um eine Achse 160 rotierbares Element 102 und ein stationäres Element 104 auf. Das stationäre Element 104 ist mit einem Magnetfeldsensor 106 ausgestattet. Das rotierbare Element 102 weist eine Welle, beispielsweise eine Getriebewelle 108, und einen Magnetfelderzeuger 110 auf. Die Getriebewelle 108 ist um die Achse 160 rotierbar. In der gezeigten Ausführungsform ist der Magnetfelderzeuger 110 als Magnet, insbesondere als Permanentmagnet, ausgebildet. Der Magnetfelderzeuger 110 ist mit der Getriebewelle 108 mittels eines Aufsatzes 112 verbunden. Dabei kann der Aufsatz 112 mittels eines Spritzgussverfahrens auf die Getriebewelle 108 aufgebracht werden, und der Magnetfelderzeuger 110 kann beispielsweise während oder nach der Ausbildung des Aufsatzes 112 installiert werden. Der als Magnet ausgebildete Magnetfelderzeuger 110 weist einen ersten Magnetpol 114 und einen zweiten Magnetpol 116 auf. Die Verbindungslinie 118 beider Magnetpole 114, 116 ist dabei azimutal ausgerichtet. Bevorzugt weist dabei die Verbindungslinie 118 keinen radialen Richtungsanteil auf. Es können aber auch Magnete verwendet werden, bei denen die Verbindungslinie 118 einen radialen Richtungsanteil aufweist, jedoch ist eine Ausrichtung des Magnetfelderzeugers 110 bevorzugt, bei dem die Verbindungslinie 118 einen zumindest überwiegenden nicht-radialen Richtungsanteil aufweist.

Ein derartiges Stellglied 100 hat ein Kennliniendiagramm 120 wie in Fig. 2 dargestellt. Das Kennliniendiagramm 120 weist eine Abszisse 122 auf, auf der die Winkelstellung des rotierbaren Elementes 102 in Grad aufgetragen ist und eine Ordinate 124, auf der das detektierbare Magnetfeld in willkürlichen Einheiten aufgetragen ist. Eine in dem Kennliniendiagramm 120 aufgetragene Magnetfeldkennlinie 126 weist den nachfolgend beschriebenen Verlauf auf. Die Magnetfeldkennlinie 126 erfährt am Nullpunkt 128, also der in Figur 1 dargestellten Stellung des rotierbaren Elementes 102, einen Nulldurchgang 130 auf. Demzufolge erfährt das durch den Magnetfeldsensor 106 detektierbare Magnetfeld einen Vorzeichenwechsel, wenn bei der Rotation des rotierbaren Elementes 102 der Magnetfelderzeuger 110 den Magnetfeldsensor 106 passiert. Die Magnetfeldkennlinie 126 ist mit einem Maximum 132 und einem Minimum 134 ausgestattet. Ist beispielsweise zudem der Magnetfelderzeuger 110 symmetrisch ausgebildet und weist der Magnetfelderzeuger 110 hinsichtlich seiner Verbindungslinie 118 keine radiale Komponente auf, so ist das Maximum 132 sowie das Minimum 134 betragsmäßig gleich groß. Ist nun wiederum das stationäre Element 104 mit einer Steuerung 136 ausgestattet, so lässt sich in der Steuerung 136 eine erste Schaltschwelle 138 und eine zweite Schaltschwelle 140 hinterlegen. Durch die erste Schaltschwelle 138 und die zweite Schallschwelle 140 kann ein Nullpunkt-Winkelstellungsbereich 142 definiert werden. Kreuzt dabei die Magnetfeldkennlinie 126 die erste Schaltschwelle 138 in einem ersten Schnittpunkt 144 beziehungsweise mit der zweiten Schaltschwelle 140 in dem zweiten Schnittpunkt 146, so kann mittels der Schnittpunkte 144, 146 eben dieser Nullpunkt-Winkelstellungsbereich 142 festgelegt werden. Im Gegensatz zu herkömmlichen Stellgliedern 100, bei welchen Maxima oder Minima durch Vorgabe einer Schaltschwelle detektiert werden, wird bei dem Stellglied 100 gemäß Figur 1 also ein Winkelstellungsbereich 142 durch die zwei Schaltschwellen 138, 140 festgelegt.

In Figur 3 ist ein weiteres Ausführungsbeispiel eines Stellgliedes 100' dargestellt. Das Stellglied 100', wie in Fig. 3 dargestellt, weist ein stationäres Element 104 und ein rotierbares Element 102' auf. Das stationäre Element 104 weist einen Magnetfeldsensor 106 auf. Das rotierbare Element 102' ist mit einem Magnetfelderzeuger 110' analog der Fig. 1 ausgestattet. Dieser Magnetfelderzeuger 110' ist mittels eines Aufsatzes 112 mit einer Getriebewelle 108 verbunden. Zudem weist die in der Fig. 3 dargestellte Ausführungsform noch einen Stützfelderzeuger 147 auf, der in diesem Ausführungsbeispiel aus zwei Stützmagneten 148, 150 aufgebaut ist, die vorwiegend radial orientiert sind. Des Weiteren ist der erste Stützmagnet 148 derart ausgerichtet, dass sein radial nach außen stehender Magnetpol 152 die gleiche Polung aufweist, wie der erste Magnetpol 114. Der zweite Stützmagnet 150 ist analog zum ersten Stützmagneten 148 dahingehend ausgebildet, dass sein radial nach außen stehender Magnetpol 154 dieselbe Polung aufweist, wie der zweite Magnetpol 116 des Magnetfelderzeugers 110.

In Fig. 4 ist eine Magnetfeldkennlinie 126' der in der Fig. 3 gezeigten Ausführungsform des Stellgliedes 100' in einem Kennliniendiagramm 120' dargestellt. Dabei lässt sich feststellen, dass sich aufgrund der Stützmagnete 148, 150 ein betragsmäßiges Absinken der Magnetfeldkennlinie 126' unter die jeweilige Schaltschwelle 138, 140 hinauszögern lässt. Aufgrund dieses Hinauszögerns ist es möglich, die bei größerer Auslenkung auftretenden weiteren Schnittpunkte 156, 158 der Magnetfeldkennlinie 126' mit den Schaltschwellen 148, 150, wie in Fig. 2 dargestellt, zu höheren Winkelstellungen hin zu verschieben. Dadurch kann eine fehlerhafte Detektion des Nulldurchganges 130 beziehungsweise des Nullpunkt-Winkelstellungsbereiches 142 verringert beziehungsweise verhindert werden. Diese Stützmagnete 148, 150 können in analoger Weise wie auch der Magnet des Magnetfelderzeugers 110 mittels des Aufsatzes 112 an der Getriebewelle 108 befestigt werden. Dabei ist die Getriebewelle 108 um die Achse 160 verdrehbar.

## Patentansprüche

1. Stellglied (100, 100') zur Auswahl mindestens eines auswählbaren Schaltzustands, insbesondere mindestens eines Schaltzustands eines Getriebes, umfassend mindestens zwei relativ zueinander bewegbare Elemente (102, 102', 104), wobei mindestens eines der Elemente (102, 102', 104) mindestens einen Magnetfelderzeuger (110, 110') aufweist und wobei das jeweils andere der Elemente (102, 102', 104) mindestens einen Magnetfeldsensor (106) aufweist, wobei der Magnetfelderzeuger (110, 110') eingerichtet ist, um bei einer Bewegung der Elemente (102, 102', 104) relativ zueinander am Ort des Magnetfeldsensors (106) ein Magnetfeld mit mindestens einem Vorzeichenwechsel bei mindestens einem Nulldurchgang (130) zu erzeugen, wobei der Nulldurchgang (130) einen ersten Stellungsbereich der Elemente (102, 102', 104) relativ zueinander von einem zweiten Stellungsbereich der Elemente (102, 102', 104) relativ zueinander trennt, wobei das Magnetfeld am Ort des Magnetfeldsensors (106) in dem ersten Stellungsbereich ein negatives Vorzeichen aufweist und wobei das Magnetfeld am Ort des Magnetfeldsensors (106) in dem zweiten Stellungsbereich ein positives Vorzeichen aufweist, **dadurch gekennzeichnet, dass** der Magnetfelderzeuger (106) weiterhin mindestens einen Stützfelderzeuger (147) aufweist, wobei der Stützfelderzeuger (147) eingerichtet ist, um dem Magnetfeld am Ort des Magnetfeldsensors (106) in zumindest einem Teilbereich des ersten Stellungsbereichs mindestens ein Stütz-Magnetfeld mit negativem Vorzeichen zu überlagern und/oder um dem Magnetfeld am Ort des Magnetfeldsensors (106) in zumindest einem Teilbereich des zweiten Stellungsbereichs mindestens ein Stütz-Magnetfeld mit positivem Vorzeichen zu überlagern, wobei der Magnetfelderzeuger (110, 110') mindestens einen Magneten aufweist, wobei der Magnet mindestens einen Nordpol (114,116) und mindestens einen Südpol (114,116) aufweist, wobei eine Verbindungslinie (118) zwischen dem Nordpol (114,116) und dem Südpol (114,116) mindestens eine parallel zu der Bewegung der Elemente (102, 102', 104) zueinander verlaufende Richtungskomponente aufweist.

2. Stellglied (100, 100') nach dem vorhergehenden Anspruch, wobei das Stellglied (100, 100') mindestens eine Steuerung (136) aufweist, wobei die Steuerung (136) eingerichtet ist, um das Magnetfeld mit mindestens einer unteren Schaltschwelle (140) und mindestens einer oberen Schaltschwelle (138) zu vergleichen und entsprechend dieser Vergleiche zu erkennen, dass der Schaltzustand ausgewählt ist.

3. Stellglied (100, 100') nach einem der vorhergehenden Ansprüche, wobei die relativ zueinander bewegbaren Elemente (102, 102', 104) ein um eine Achse (160) rotierbares Element (102, 102') und mindestens ein statisches Element (104) aufweisen.

4. Stellglied (100, 100') nach dem vorhergehenden Anspruch, wobei der Magnetfelderzeuger (110, 110') mit dem rotierbaren Element (102, 102') verbunden ist und wobei der Magnetfeldsensor (106) mit dem statischen Element (104) verbunden ist.

5. Stellglied (100, 100') nach einem der vorhergehenden Ansprüche, wobei der Magnet mindestens einen Permanentmagneten aufweist, vorzugsweise mindestens einen Dipol-Permanentmagneten.

6. Stellglied (100, 100') nach einem der vorhergehenden Ansprüche, wobei die Verbindungslinie (118) mindestens eine nicht-radial zu einer Achse (160) einer Rotation der Elemente (102, 102', 104) zueinander verlaufende Richtungskomponente und bevorzugt eine azimutal zu der Achse (160) verlaufende Richtungskomponente aufweist.

7. Stellglied (100, 100') nach einem der vorhergehenden Ansprüche, wobei der Magnetfelderzeuger (110, 110') derart eingerichtet ist, dass das Magnetfeld bei einer Relativbewegung der Elemente (102, 102', 104) zueinander, insbesondere bei einer Rotation des rotierbaren Elements (102, 102') um die Achse (160), einen symmetrischen Verlauf zu dem Nulldurchgang (130) aufweist.

8. Stellglied (100, 100') nach einem der vorhergehenden Ansprüche, wobei der Stützfelderzeuger (147) mindestens einen Stützmagneten (148,150), insbesondere mindestens einen Permanentmagneten, vorzugsweise mindestens einen Dipol-Permanentmagneten, aufweist, wobei der Stützmagnet (148,150) mindestens einen Nordpol und mindestens einen Südpol aufweist, wobei eine Verbindungslinie zwischen dem Nordpol und dem Südpol mindestens eine Richtungskomponente senkrecht zu der Bewegung der Elemente (102, 102', 104) zueinander aufweist, vorzugsweise eine radial zu einer Achse (160) einer Rotation der Elemente (102, 102', 104) zueinander verlaufende Richtungskomponente und besonders bevorzugt eine und vorzugsweise radial verläuft.

9. Stellglied (100, 100') nach dem vorhergehenden Anspruch, wobei mindestens zwei Stützmagnete (148,150) auf einander gegenüberliegenden Seiten des Magnetfelderzeugers (106) vorgesehen sind, vorzugsweise symmetrisch zu dem Magnetfelderzeuger (106).

10. Stellglied (100, 100') nach dem vorhergehenden Anspruch, wobei die Stützmagnete (148,150) auf den einander gegenüberliegenden Seiten des Magnetfelderzeugers (106) zueinander entgegengesetzt ausgerichtet sind.

11. Schaltgetriebe zum Einsatz in einem Kraftfahrzeug, insbesondere zum Einsatz in einem Kraftfahrzeug mit Start-Stopp-Automatik, umfassend mindestens ein Stellglied (100, 100') nach einem der vorhergehenden Ansprüche, zur Auswahl mindestens eines auswählbaren Schaltzustands des Schaltgetriebes.

## Claims

1. Positioning member (100, 100') for selecting at least one selectable switched state, in particular at least one switched state of a transmission, comprising at least two elements (102, 102', 104) which can move relative to one another, wherein at least one of the elements (102, 102', 104) has at least one magnetic field generator (110, 110'), and wherein the respective other element of the elements (102, 102', 104) has at least one magnetic field sensor (106), wherein the magnetic field generator (110, 110') is configured to generate, in the event of a movement of the elements (102, 102', 104) relative to one another at the location of the magnetic field sensor (106), a magnetic field having at least one sign change at at least one zero crossing (130), wherein the zero crossing (130) separates a first positioning range of the elements (102, 102', 104) relative to one another from a second positioning range of the elements (102, 102', 104) relative to one another, wherein the magnetic field has a negative sign at the location of the magnetic field sensor (106) in the first positioning range, and wherein the magnetic field has a positive sign at the location of the magnetic field sensor (106) in the second positioning range, **characterized in that** the magnetic field generator (106) also has at least one supporting field generator (147), wherein the supporting field generator (147) is set up to superimpose at least one supporting magnetic field with a negative sign on the magnetic field at the location of the magnetic field sensor (106) in at least one partial range of the first positioning range and/or to superimpose at least one supporting magnetic field with a positive sign on the magnetic field at the location of the magnetic field sensor (106) in at least one partial range of the second positioning range, wherein the magnetic field generator (110, 110') has at least one magnet, wherein the magnet has at least one north pole (114, 116) and at least one south pole (114, 116), wherein a connecting line (118) between the north pole (114, 116) and the south pole (114, 116) has at least one directional component running parallel to the movement of the elements (102, 102', 104) with respect to one another.

2. Positioning member (100, 100') according to the preceding claim, wherein the positioning member (100, 100') has at least one controller (136), wherein the controller (136) is configured to compare the magnetic field with at least one lower switching threshold (140) and at least one upper switching threshold (138) and to detect in accordance with these comparisons that the switched state is selected.

3. Positioning member (100, 100') according to one of the preceding claims, wherein the elements (102, 102', 104) which can be moved relative to one another have an element (102, 102') which can rotate about an axis (160) and at least one static element (104).

4. Positioning member (100, 100') according to the preceding claim, wherein the magnetic field generator (110, 110') is connected to the rotatable element (102, 102'), and wherein the magnetic field sensor (106) is connected to the static element (104).

5. Positioning member (100, 100') according to one of the preceding claims, wherein the magnet has at least one permanent magnet, preferably at least one dipole permanent magnet.

6. Positioning member (100, 100') according to one of the preceding claims, wherein the connecting line (118) has at least one directional component running non-radially with respect to an axis (160) of a rotation of the elements (102, 102', 104) with respect to one another, and preferably has a directional component running in an azimuthal fashion with respect to the axis (160).

7. Positioning member (100, 100') according to one of the preceding claims, wherein the magnetic field generator (110, 110') is configured in such a way that in the case of a relative movement of the elements (102, 102', 104) with respect to one another, in particular in the case of a rotation of the rotatable elements (102, 102') about the axis (160), the magnetic field has a symmetrical profile with respect to the zero crossing (130).

8. Positioning member (100, 100') according to one of the preceding claims, wherein the supporting field generator (147) has at least one supporting magnet (148, 150), in particular at least one permanent magnet, preferably at least one dipole permanent magnet, wherein the supporting magnet (148, 150) has at least one north pole and at least one south pole, wherein a connecting line between the north pole and the south pole has at least one directional component perpendicular to the movement of the elements (102, 102', 104) with respect to one another, preferably a directional component running radially with respect to an axis (160) of a rotation of the elements (102, 102', 104) with respect to one another and particularly preferably a and preferably extends radially.

9. Positioning member (100, 100') according to the preceding claim, wherein at least two supporting magnets (148, 150) are provided on opposite sides of the magnetic field generator (106), preferably symmetrically with respect to the magnetic field generator (106).

10. Positioning member (100, 100') according to the preceding claim, wherein the supporting magnets (148, 150) are oriented oppositely with respect to one another on the opposite sides of the magnetic field generator (106).

11. Transmission for use in a motor vehicle, in particular for use in a motor vehicle having an automatic start/stop system comprising at least one positioning member (100, 100') according to one of the preceding claims, for selecting at least one selectable switched state of the transmission.

## Revendications

1. Actionneur (100, 100') pour la sélection d'au moins un état de commutation sélectionnable, en particulier d'au moins un état de commutation d'une transmission, comprenant au moins deux éléments (102, 102', 104) déplaçables l'un par rapport à l'autre, au moins l'un des éléments (102, 102', 104) présentant au moins un générateur de champ magnétique (110, 110') et l'autre des éléments (102, 102', 104) présentant à chaque fois au moins un capteur de champ magnétique (106), le générateur de champ magnétique (110, 110') étant prévu pour générer, lors d'un mouvement des éléments (102, 102', 104) les uns par rapport aux autres sur le site du capteur de champ magnétique (106), un champ magnétique avec au moins un changement de signe lors d'au moins un passage par zéro (130), le passage par zéro (130) séparant une première zone de position des éléments (102, 102', 104) les uns par rapport aux autres, d'une deuxième zone de position des éléments (102, 102', 104) les uns par rapport aux autres, le champ magnétique sur le site du capteur de champ magnétique (106) dans la première zone de position présentant un signe négatif et le champ magnétique sur le site du capteur de champ magnétique (106) dans la deuxième zone de position présentant un signe positif, **caractérisé en ce que** le générateur de champ magnétique (106) présente en outre au moins un générateur de champ de support (147), le générateur de champ de support (147) étant prévu pour superposer au champ magnétique sur le site du capteur de champ magnétique (106) dans au moins une région partielle de la première zone de position, au moins un champ magnétique de support de signe négatif et/ou pour superposer au champ magnétique sur le site du capteur de champ magnétique (106) dans au moins une région partielle de la deuxième zone de position au moins un champ magnétique de support de signe positif, le générateur de champ magnétique (110, 110') présentant au moins un aimant, l'aimant présentant au moins un pôle nord (114, 116) et au moins un pôle sud (114, 116), une ligne de liaison (118) entre le pôle nord (114, 116) et le pôle sud (114, 116) présentant au moins une composante de direction s'étendant parallèlement au mouvement des éléments (102, 102', 104) les uns par rapport aux autres.

2. Actionneur (100, 100') selon la revendication précédente, dans lequel l'actionneur (100, 100') présente au moins une commande (136), la commande (136) étant prévue pour comparer le champ magnétique avec au moins un seuil de commutation inférieur (140) et au moins un seuil de commutation supérieur (138), et pour détecter en fonction de ces comparaisons, que l'état de commutation est sélectionné.

3. Actionneur (100, 100') selon l'une quelconque des revendications précédentes, dans lequel les éléments (102, 102', 104) déplaçables les uns par rapport aux autres présentent un élément (102, 102') pouvant tourner autour d'un axe (160) et au moins un élément statique (104).

4. Actionneur (100, 100') selon la revendication précédente, dans lequel le générateur de champ magnétique (110, 110') est relié à l'élément rotatif (102, 102'), et dans lequel le capteur de champ magnétique (106) est relié à l'élément statique (104).

5. Actionneur (100, 100') selon l'une quelconque des revendications précédentes, dans lequel l'aimant présente au moins un aimant permanent, de préférence au moins un aimant permanent dipolaire.

6. Actionneur (100, 100') selon l'une quelconque des revendications précédentes, dans lequel la ligne de liaison (118) présente au moins une composante directionnelle s'étendant non radialement par rapport à un axe (160) de rotation des éléments (102, 102', 104) les uns par rapport aux autres et de préférence une composante directionnelle s'étendant de manière azimutale par rapport à l'axe (160).

7. Actionneur (100, 100') selon l'une quelconque des revendications précédentes, dans lequel le générateur de champ magnétique (110, 110') est prévu de telle sorte que le champ magnétique, dans le cas d'un mouvement relatif des éléments (102, 102', 104) les uns par rapport aux autres, notamment dans le cas d'une rotation de l'élément rotatif (102, 102') autour de l'axe (160), présente une allure symétrique par rapport au passage par zéro (130).

8. Actionneur (100, 100') selon l'une quelconque des revendications précédentes, dans lequel le générateur de champ de support (147) présente au moins un aimant de support (148, 150), en particulier au moins un aimant permanent, de préférence au moins un aimant permanent dipolaire, l'aimant de support (148, 150) présentant au moins un pôle nord et au moins un pôle sud, une ligne de liaison entre le pôle nord et le pôle sud présentant au moins une composante directionnelle perpendiculaire au déplacement des éléments (102, 102', 104) les uns par rapport aux autres, de préférence une composante directionnelle s'étendant radialement par rapport à un axe (160) de rotation des éléments (102, 102', 104) les uns par rapport aux autres, et particulièrement préférablement une et s'étend de préférence radialement [sic].

9. Actionneur (100, 100') selon la revendication précédente, dans lequel au moins deux aimants de support (148, 150) sont prévus sur des côtés opposés du générateur de champ magnétique (106), de préférence symétriquement par rapport au générateur de champ magnétique (106).

10. Actionneur (100, 100') selon la revendication précédente, dans lequel les aimants de support (148, 150) sont orientés de manière opposée l'un à l'autre sur les côtés opposés du générateur de champ magnétique (106).

11. Boîte de vitesse pour l'utilisation dans un véhicule automobile, en particulier pour l'utilisation dans un véhicule automobile avec un système automatique d'arrêt et de démarrage, comprenant au moins un actionneur (100, 100') selon l'une quelconque des revendications précédentes, pour la sélection d'au moins un état de commutation sélectionnable de la boîte de vitesse.
